(19) Europäisches Patentamt
European Patent Office
Office européen des brevets

(11) **EP 3 484 077 B1**

(12) **EUROPEAN PATENT SPECIFICATION**

(45) Date of publication and mention
of the grant of the patent:
**17.03.2021 Bulletin 2021/11**

(21) Application number: **18807541.0**

(22) Date of filing: **27.06.2018**

(51) Int Cl.:
**H04L 1/00** (2006.01)

(86) International application number:
**PCT/CN2018/093030**

(87) International publication number:
**WO 2019/001447 (03.01.2019 Gazette 2019/01)**

(54) **ENCODING METHOD, WIRELESS DEVICE, AND COMPUTER READABLE STORAGE MEDIUM**

CODIERUNGSVERFAHREN, DRAHTLOSE VORRICHTUNG UND COMPUTERLESBARES SPEICHERMEDIUMN

PROCÉDÉ DE CODAGE, DISPOSITIF SANS FIL ET SUPPORT D'INFORMATIONS LISIBLE PAR ORDINATEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.06.2017 CN 201710503568**

(43) Date of publication of application:
**15.05.2019 Bulletin 2019/20**

(73) Proprietor: **Huawei Technologies Co., Ltd.**
**Longgang District**
**Shenzhen, Guangdong 518129 (CN)**

(72) Inventors:
• **ZHANG, Huazi**
**Shenzhen, Guangdong 518129 (CN)**
• **LI, Rong**
**Shenzhen Guangdong 518129 (CN)**
• **ZHANG, Gongzheng**
**Shenzhen, Guangdong 518129 (CN)**
• **XU, Chen**
**Shenzhen Guangdong 518129 (CN)**

(74) Representative: **Pfenning, Meinig & Partner mbB**
**Patent- und Rechtsanwälte**
**Joachimsthaler Straße 10-12**
**10719 Berlin (DE)**

(56) References cited:
WO-A1-2015/139297    WO-A1-2017/215494
CN-A- 106 817 195    CN-A- 106 877 973
CN-A- 107 342 846    US-A1- 2016 241 355

• **ZTE: "Polar Codes Contruction and Rate Matching Scheme", 3GPP DRAFT; R1-1707183 POLAR CODES CONSTRUCTION AND RATE MATCHING SCHEME_FINAL, 3RD GENERATION PARTNERSHIP PROJECT (3GPP), MOBILE COMPETENCE CENTRE ; 650, ROUTE DES LUCIOLES ; F-06921 SOPHIA-ANTIPOLIS , vol. RAN WG1, no. Hangzhou, China; 20170515 - 20170519 7 May 2017 (2017-05-07), XP051262938, Retrieved from the Internet: URL:http://www.3gpp.org/ftp/tsg_ran/WG1_RL 1/TSGR1_89/Docs/ [retrieved on 2017-05-07]**
• **MEDIATEK INC: "Polar Code Size and Rate-Matching Design for NR Control Channels", 3GPP DRAFT; R1-1702735_POLAR CODE SIZE AND RATE-MATCHING DESIGN FOR NR CONTROL CHANNELS_FINAL, 3RD GENERATION PARTNERSHIP PROJECT (3GPP), MOBILE COMPETENCE CENTRE ; 650, ROUTE DES LUCIOLES ; F-06921 S , vol. RAN WG1, no. Athens, Greece; 20170213 - 20170217 7 February 2017 (2017-02-07), XP051221575, Retrieved from the Internet: URL:http://www.3gpp.org/ftp/tsg_ran/WG1_RL 1/TSGR1_88/Docs/ [retrieved on 2017-02-07]**
• **NEC: "Design of Assistance Bit Aided Polar Codes for NR Control Channel", 3GPP TSG RAN WGI Meeting #89, R1-1709497, 17 May 2017 (2017-05-17), XP051285167,**
• **HUAWEI et al.: "Analysis of the Sequence of Polar Codes", 3GPPP TSG RAN WG1 Meeting #89, R1-1708157, 14 May 2017 (2017-05-14), XP051273353,**

## Description

## TECHNICAL FIELD

This application relates to wireless communication field, especially to a channel coding method and device.

## BACKGROUND

A communications system usually uses channel coding to improve reliability of data transmission and ensure communication quality. Polar (Polar) coding is a coding manner that can achieve Shannon capacity theoretically and that has a simple encoding and decoding method. A polar code is a type of linear block code. A generator matrix of the polar code is $G_N$, and a coding process of the polar code is $X_1^N = u_1^N G_N$, where $u_1^N = (u_1, u_2, \ldots, u_N)$ is a binary row vector, $G_N = F_2^{\otimes(\log_2(N))}$, and a length of a mother code sequence N = $2^n$, where n is a positive integer. $F_2 = \begin{bmatrix} 1 & 0 \\ 1 & 1 \end{bmatrix}$, where $F_2^{\otimes(\log_2(N))}$ is a Kronecker product of $F_2$ and $F^{\otimes(\log_2(N))} = F \otimes F^{\otimes((\log_2(N))-1)}$ is defined.

During a coding process of a polar code, some bits in $u_1^N$ are used to carry information and are referred to as information bits. A set of sequence numbers of the information bits is denoted as A. The other bits are set to fixed values pre-agreed on by a receive end and a transmit end and are referred to as fixed bits. A set of sequence numbers of the fixed bits is represented by a complementary set $A^c$ of A. Without loss of generality, the fixed bits are usually set to 0. Actually, a fixed bit sequence may be set to any values as long as the receive end and the transmit end pre-agree with each other. Therefore, a coded bit sequence of the polar code may be obtained by using the following method:

$$x_1^N = u_A G_N(\mathcal{A})$$,

where $u_A$ is a set of information bits in $u_1^N$, $u_A$ is a row vector having a length of K, that is, $||=K$, $|\cdot|$ indicates a quantity of elements in a set, that is, K indicates a quantity of elements in the set A. $G_N$(A) is a submatrix, obtained from rows corresponding to indexes in the set A, in a matrix $G_N$. $G_N$(A) is a matrix of $K \times N$. By using a CRC-aided enhanced SC decoding algorithm, the polar code may achieve FER performance superior to LDPC and Turbo codes.

In the prior art, to support all combinations, required by a system, of code lengths and code rates, a large quantity of mother code sequences need to be stored, and therefore storage overheads of the system are extremely large.

WO 2017/215494 cited under the provisions of Art. 54(3) EPC, discloses that a plurality of bits are mapped to a subset of positions of an input vector according to an information sequence, the remaining positions of the input vector are set as frozen values that are known by a decoder.

R1-1707183, POLAR CODES CONSTRUCTION AND RATE MATCHING SCHEME_FINAL, 3RD GENERATION PARTNERSHIP PROJECT (3GPP), MOBILE COMPETENCE CENTRE; 650, ROUTE DES LUCIOLES; F-06921 SOPHIA-ANTIPOLIS, vol. RAN WG1, no. Hangzhou, China; 20170515 - 20170519 7 May 2017, discloses that a same sequence is used for polar code construction and rate matching.

## SUMMARY

This application provides a coding method, a wireless device, an apparatus, and a computer readable storage medium so as to decrease storage overheads of a system.

According to a first aspect, this application provides a coding method according to claim 1 and an apparatus according to claim 9.

According to a second aspect, this application provides a wireless device according to claim 7.

According to a third aspect, this application further provides a computer program product according to claim 8.

According to the technical solutions provided in this application, a constructed sequence that is suitable for various puncturing/shortening proportions may be generated, and channel reliability sorting in the constructed sequence is more appropriate, thereby decreasing a bit error rate.

## BRIEF DESCRIPTION OF DRAWINGS

To describe the technical solutions in the embodiments of the present invention more clearly, the following briefly describes the accompanying drawings required for describing the embodiments of the present invention.

FIG. 1 is a schematic structural diagram of a wireless communications network according to an embodiment of the present invention;

FIG. 2 is a schematic diagram of a coding and decoding procedure according to an embodiment of the present invention;

FIG. 3 is a schematic flowchart of a coding method according to an embodiment of the present invention;

FIG. 4 is a schematic diagram of a method for adjusting a sequence according to an embodiment of the present invention;

FIG. 5(a) and FIG. 5(b) are schematic diagrams of adjusting a sequence according to an embodiment of the present invention;

FIG. 6 is a schematic diagram of adjusting a sequence according to an embodiment of the present invention;

FIG. 7 is a schematic flowchart of performing an adjustment method by a wireless device according to an embodiment of the present invention;

FIG. 8 is a schematic structural diagram of a wireless device according to an embodiment of the present invention;

FIG. 9(a) and FIG. 9(b) are schematic diagrams of extracting a short sequence from a long sequence according to an embodiment of the present invention;

FIG. 10(a) and FIG. 10(b) are schematic diagrams of extracting a short sequence from a long sequence according to an embodiment of the present invention; and

FIG. 11(a) and FIG. 11(b) are schematic diagrams of a coding structure according to an embodiment of the present invention.

## DESCRIPTION OF EMBODIMENTS

The following describes the technical solutions in the embodiments of the present invention with reference to the accompanying drawings in the embodiments of the present invention. Apparently, the described embodiments are merely some rather than all of the embodiments of the present invention. All other embodiments obtained by a person of ordinary skill in the art based on the embodiments of the present invention without creative efforts shall fall within the protection scope of the present invention.

The embodiments of the present invention may be applied to various communications systems, such as a Global System for Mobile Communications (Global System for Mobile communication, GSM) system, a Code Division Multiple Access (Code Division Multiple Access, CDMA) system, a Wideband Code Division Multiple Access (Wideband Code Division Multiple Access, WCDMA) system, a general packet radio service (General Packet Radio Service, GPRS), a Long Term Evolution (Long Term Evolution, LTE) system, an LTE frequency division duplex (Frequency Division Duplex, FDD) system, an LTE time division duplex (Time Division Duplex, TDD) system, or a Universal Mobile Telecommunications System (Universal Mobile Telecommunications System, UMTS). Information or data coded by using a conventional Turbo code or LDPC code by a base station or a terminal in the foregoing systems may be coded by using a polar code in the embodiments of the present invention.

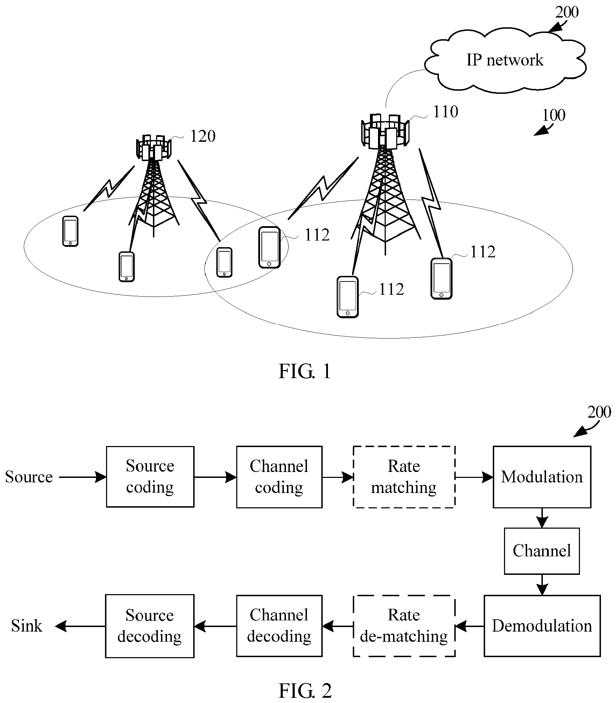

FIG. 1 is a schematic structural diagram of a wireless communications network according to an embodiment of the present invention. FIG. 1 is merely an example. Another wireless network that may use a coding method or apparatus in the embodiments of the present invention shall fall within the protection scope of the present invention.

As shown in FIG. 1, a wireless communications network 100 includes a network device 110 and a terminal 112. When the wireless communications network 100 includes a core network, the network device 110 may be connected to the core network. The network device 110 may communicate with an IP network 200, such as the Internet (internet), a private IP network, or another data network. The network device provides a service for a terminal in a coverage area of the network device. For example, as shown in FIG. 1, the network device 110 provides radio access for one or more terminals in a coverage area of the network device 110. In addition, coverage areas of network devices may overlap. For example, coverage areas of the network device 110 and a network device 120 overlap. The network devices may communicate with each other, for example, the network device 110 and the network device 120 may communicate with each other.

The network device may be a device configured to communicate with a terminal device. For example, the network device may be a base transceiver station (Base Transceiver Station, BTS) in a GSM system or a CDMA system, or may be a NodeB (NodeB, NB) in a WCDMA system, or may be an evolved NodeB (Evolved Node B, eNB or eNodeB) in an LTE system or a network-side device in a future 5G network. Alternatively, the network device may be a repeater station, an access point, an in-vehicle device, or the like. In a device-to-device (Device to Device, D2D) communications system, the network device may be a terminal that functions as a base station.

The terminal may be user equipment (User Equipment, UE), an access terminal, a subscriber unit, a mobile station, a remote station, a remote terminal, a mobile device, a user terminal, a wireless communications device, a user agent, or a user apparatus. The access terminal may be a cellular phone, a cordless telephone set, a Session Initiation Protocol (Session Initiation Protocol, SIP) phone, a wireless local loop (Wireless Local Loop, WLL) station, a personal digital assistant (Personal Digital Assistant, PDA), a handheld device or a computing device having a wireless communication function, another processing device connected to a wireless modem, an in-vehicle device, a wearable device, a terminal device in a future 5G network, or the like.

When the network device communicates with the terminal, the network device/terminal needs to code to-be-sent data/information according to a procedure shown in FIG. 2, and needs to decode received data/information. For ease of description, the network device and the terminal are collectively referred to as a wireless device in the following.

As shown in FIG. 2, after obtaining the to-be-sent data/information (which may also be referred to as a source), the wireless device sends the data/information on a channel after sequentially performing source coding, channel coding, rate matching, and modulation. After receiving a signal, a peer end obtains final data/information (which may also be referred to as a sink) after sequentially performing demodulation, rate de-matching, channel decoding, and source decoding.

The embodiments of the present invention are mainly related to channel coding, which is described in the following by using specific examples. It may be learned, according to the description in BACKGROUND, that in a polar coding process, a mother code length N is used, but the mother code length N may probably not match a quantity M (or a target code length M) of actually available physical channels. Therefore, rate matching further needs to be performed after coding by using a polar code. Currently, two types of rate matching methods are usually used: puncturing and shortening. An objective of puncturing or shortening is to remove some bits from a to-be-sent bit sequence, so that to-be-sent bit sequence can match a carrying capability of a physical channel.

To improve polar code performance, in the polar code, channels corresponding to sequence numbers of K most reliable subchannels are usually selected from a mother code that has a length of N to send information bits (or information bits and CRC bits), so as to ensure optimal decoding performance. Channel indexes in the mother code that has the length of N are sorted by reliability. If the rate matching is not used, the sequence numbers corresponding to the K most reliable subchannels may be easily selected from the mother code to send information bits (or information bits and CRC bits). However, after the rate matching, the mother code sequence that has the length of N becomes a constructed sequence that has a length of M. In this case, after M channels in the constructed sequence are re-sorted by reliability through emulation, it is found that sorting of the M channels in the constructed sequence changes, compared with the original sorting in the mother code sequence. In this case, it is probably inaccurate if K most reliable subchannels are selected directly based on the reliability sorting in the mother code sequence.

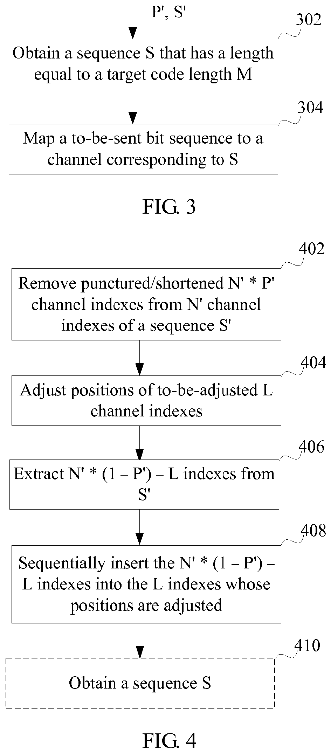

To resolve the foregoing problem, as shown in FIG. 3, an embodiment of the present invention provides the following method, which is performed by a wireless device.

302. Obtain, based on a puncturing/shortening proportion P' and a prestored sequence S', a constructed sequence S that has a length equal to a target code length M.

S' includes N' channel indexes sorted by channel reliability, and sorting of channel indexes in S is the same as or different from sorting of channel indexes in S'.

304. Map to-be-sent bits to a channel corresponding to S.

If N' = M, S' is the constructed sequence S, that is, S = S', and the sorting of the channel indexes in S is the same as the sorting of the channel indexes in S'.

If N' ≠ M, the foregoing step 302 may be: first obtaining the prestored sequence S' based on the puncturing/shortening proportion P', and then obtaining, based on the prestored sequence S', a sequence that has a length of M.

For example, if N' > M, S may be obtained, after N' * P' channels are removed from N' channels corresponding to S', by adjusting indexes of remaining N' * (1 - P') channels based on a preset adjustment sequence, and S includes some or all of the indexes of the remaining N' * (1 - P') channels. The following describes how to perform adjustment based on the preset adjustment sequence.

If N' > M, S may be a sequence that is generated based on S' and that has a length of M. For example, an offset N' is added to each index in S' to obtain a sequence that has a length of 2N', or a similar method is used to obtain a sequence S" that has a length of N", and N" > M. S may be obtained, after N" * P' channels are removed from N" channels corresponding to N", by adjusting indexes of remaining N" * (1 - P') channels based on the preset adjustment sequence, and S includes some or all of the indexes of the remaining N' * (1 - P') channels. A correspondence may exist between P' and S'. For example, before performing step 302, the wireless device may prestore the following Table 1. Table 1 includes correspondences between P' and S'. There may be n values of P', namely, $P_0'$ to $P_n'$. Different values of P' correspond to different sequences S', namely, $S_0$ to $S_n$.

The wireless device may obtain a corresponding sequence S' based on the puncturing/shortening proportion P' and by querying Table 1. P' herein indicates an actual puncturing/shortening proportion.

**Table 1**

| Value of P' | Sequence S' |
|---|---|
| $P_0'$ | $S_0$ |
| $P_1'$ | $S_1$ |
| $P_2'$ | $S_2$ |
| ... | ... |
| $P_n'$ | $S_n$ |

In another example, the foregoing P' may not be an actual puncturing/shortening proportion but an estimated value of a puncturing/shortening proportion, and a plurality of actual puncturing/shortening proportions may correspond to one value of P'. For ease of description, the following uses P to represent the actual puncturing/shortening proportion. For example, the wireless device may alternatively prestore the following Table 2, and Table 2 includes correspondences between P, P', and S'. Values of P have n+1 ranges (referring to a column 1 in Table 2, some ranges in the n+1 ranges may be specific values, which, for ease of description, are collectively referred to as ranges). There may be n+1 values of the corresponding P', namely, $P_0'$ to $P_n'$, and different values correspond to different sequences S', namely, $S_0$ to $S_n$. The wireless device may obtain a corresponding sequence S' based on the puncturing/shortening proportion P and by querying Table 2.

**Table 2**

| Value of P | Value of P' | Sequence S' |
|---|---|---|
| $P_0$ | $P_0'$ | $S_0$ |
| $P_0 < P \leq P_1$ | $P_1'$ | $S_1$ |
| $P_1 < P \leq P_2$ | $P_2'$ | $S_2$ |
| ... | ... | ... |
| $P_{n-1} < P \leq P_n$ | $P_n'$ | $S_n$ |

Certainly, during actual application, simple variations may be made to the foregoing table, for example, the wireless device may store the following Table 3. The value of P' in Table 3 is not an estimated value, but represents a value or a value range of an actual puncturing/shortening proportion.

**Table 3**

| Value of P' | Sequence S' |
|---|---|
| $P' = P_0$ | $S_0$ |
| $P_0 < P' \leq P_1$ | $S_1$ |
| $P_1 < P' \leq P_2$ | $S_2$ |
| ... | ... |
| $P_{n-1} < P' \leq P_n$ | $S_n$ |

For ease of understanding, the following gives specific examples for description. For example, for a rate matching manner of puncturing, the following Table 4 may be stored. P' in Table 4 represents a puncturing proportion. Various constructed sequences that have a length of M (M has different values) may be constructed by using four sequences S' in Table 4.

**Table 4**

| Value of P' | Sequence S' |
|---|---|
| $0 \leq P' < 1/4$ | $S_0$ |
| $1/4 \leq P' < 3/8$ | $S_{p1}$ |
| $3/8 \leq P' < 7/16$ | $S_{p2}$ |
| $7/16 \leq P' < 1/2$ | $S_0$ |

For another example, for a rate matching manner of shortening, the following Table 5 may be stored. P' in Table 5 represents an actual puncturing/shortening proportion. Various constructed sequences that have a length of M (M has different values) may be constructed by using three sequences S' in Table 5.

**Table 5**

| Value of P' | Sequence S' |
|---|---|
| $0 \leq P' < 1/2$ | $S_0$ |
| $1/2 \leq P' < 5/8$ | $S_{s1}$ |
| $5/8 \leq P' < 1/2$ | $S_0$ |

S0 in the foregoing table may be a basic sequence. To reduce storage overheads, the wireless device may not need to store a plurality of sequences S', for example, stores only the sequence S0, and other sequences may be generated based on S0. For example, S0 may be a largest mother code sequence, and other sequences such as $S_{p1}$, $S_{p2}$, or $S_{s1}$ may be extracted from S0 according to a particular order. S0 may alternatively be a short sequence, other sequences may be generated based on S0, and there are a plurality of generation manners. For example, S0 and another short sequence are combined to generate another sequence, or after an offset is added to each channel sequence number in S0, a sequence obtained after the offset is added and S0 construct another sequence. This is not a focus of the present invention, and therefore details are not further described herein.

If the length of S' is exactly equal to M, rate matching is not needed. Channels used for transmitting K information bits may be selected directly based on S'.

If the length of S' is not equal to M, rate matching is related. For example, if the length of S' is greater than M, a constructed sequence that has a length of M may be obtained by using a method shown in FIG. 4.

402. Puncture/shorten N' * P' channel indexes from N' channel indexes of S'.

During specific implementation, the N' * P' channel indexes may be removed, or N' * P' subchannels whose reliability is decreased to 0 due to puncturing/shortening are frozen, or reliability sorting values of the punctured/shortened N' * P' channel indexes are set to the lowest. For example, index values corresponding to N' * P' channels are assigned to $Q_1, ..., Q_{N' * P'}$, indicating that the N' * P' channels are subchannels with lowest reliability. Alternatively, simply, the subchannels whose reliability is decreased to 0 due to puncturing/shortening are directly frozen.

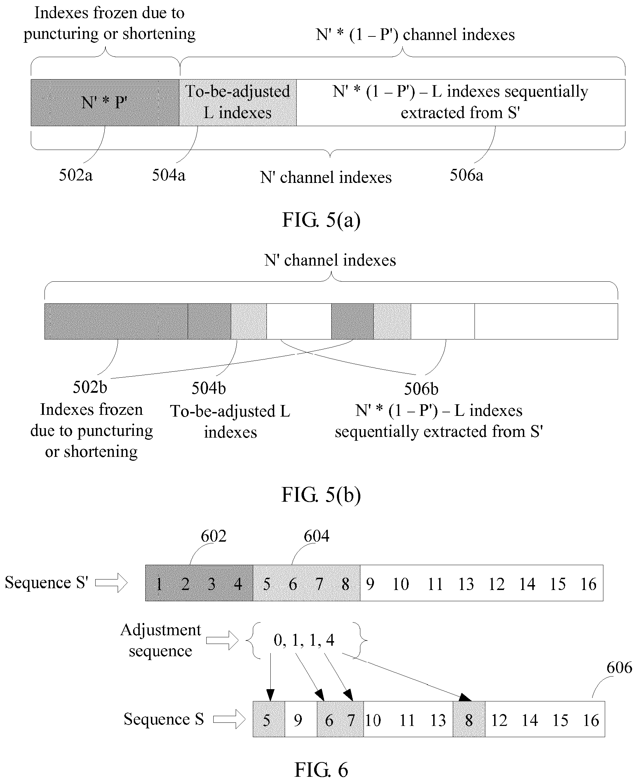

Positions of the foregoing punctured/shortened N' * P' subchannels may be consecutive, as shown by 502a in FIG. 5(a). An order of puncturing/shortening may be from front to back, or from back to front, or channel indexes in a plurality of centrally consecutive positions are punctured/shortened. Positions of the punctured/shortened N' * P' subchannels may alternatively be dispersed, irregularly or regularly. For example, one or more channel indexes are punctured/shortened at an interval of T bits. The positions of the punctured/shortened N' * P' subchannels may be a result subject to both the foregoing two manners. For example, as shown by 502b in FIG. 5(b), when $0 < P \leq 1/4$, a consecutive puncturing/shortening manner is used; or when $1/4 < P \leq 1/2$, a dispersed puncturing/shortening manner is used. The puncturing/shortening positions shown in FIG. 5(a) and FIG. 5(b) are merely examples. During actual application, a puncturing/shortening position may be a mirror, in a left or right direction with the middle as an axis, of the position shown in FIG. 5(a) and FIG. 5(b), or may be another position.

If a puncturing proportion is slightly less than 1/4, that is, $N' * 3/4 < M < \beta * (N' * 3/4)$, an $i (< N'/4)$ part is forcibly frozen, and a corresponding adjustment short sequence is all all zeros, that is, the 504a part is not adjusted, where $\beta > 1$, $\beta = 1 + 1/16, 1 + 1/8, 1 + 3/16, ...$, or $\beta$ is a function of K0/M0 or K0/N0. In this case, a quantity of indexes shown by 502a plus a quantity of indexes shown by 504a in FIG. 5(a) is less than N'/4.

An object of the foregoing puncturing/shortening may be a sequence obtained based on natural sorting by channel index, for example, {1, 2, 3, 4, ..., 512} and {1, 2, 3, 4, ..., 1024}, or may be a sequence after channel indexes are sorted by channel reliability. This is not limited herein.

404. Adjust positions of to-be-adjusted L channel indexes based on an adjustment sequence.

The to-be-adjusted L channel indexes may be consecutive, as shown by 504a in FIG. 5(a), or the to-be-adjusted L channel indexes may be dispersed, as shown by 504b in FIG. 5(b). The to-be-adjusted L channel indexes may alternatively be partially consecutive and partially dispersed.

Assuming that the L channel indexes are $\{X_1, X_2, ..., X_{L-1}, X_L\}$, and an adjustment sequence corresponding to the L channel indexes is $\{a_1, a_2, ..., a_{L-1}, a_L\}$, the positions of the to-be-adjusted L channel indexes are adjusted based on the adjustment sequence, which indicates that, a position of an index $X_1$ needs to be moved ai positions backward or forward (for example, that ai is a positive number indicates moving backward; that $a_1$ is a negative number indicates moving forward), a position of an index $X_2$ needs to be moved $a_2$ positions backward or forward, a position of an index $X_{L-1}$ needs to be moved $a_{L-1}$ positions backward or forward, and a position of an index $X_L$ needs to be moved $a_L$ positions backward or forward.

406. Extract N * (1 - P') - L indexes from S'.

If S' is a Q sequence, N * (1 - P') - L channel indexes may be sequentially extracted from the Q sequence. As shown in FIG. 5(a), it is assumed that the length of S' is 512, and channel indexes whose values are 129 to 512 need to be filled in the 506a part. In this case, only channel indexes whose index values are 129 to 512 need to be sequentially extracted from the Q sequence that has the length of 512. Sorting of 129 to 512 channel indexes is consistent with sorting in the Q sequence (sorting consistency herein means that a relative order of indexes is consistent).

Alternatively, as shown in FIG. 5(b), it is assumed that the length of S' is still 512, and channel indexes whose values are 192 to 256 and 320 to 512 need to be filled in the 506b part. In this case, only channel indexes whose index values are 192 to 256 and 320 to 512 need to be sequentially extracted from the Q sequence that has the length of 512. Sorting of 192 to 256 and 320 to 512 channel indexes is consistent with sorting in the Q sequence (sorting consistency herein means that a relative order of indexes is consistent).

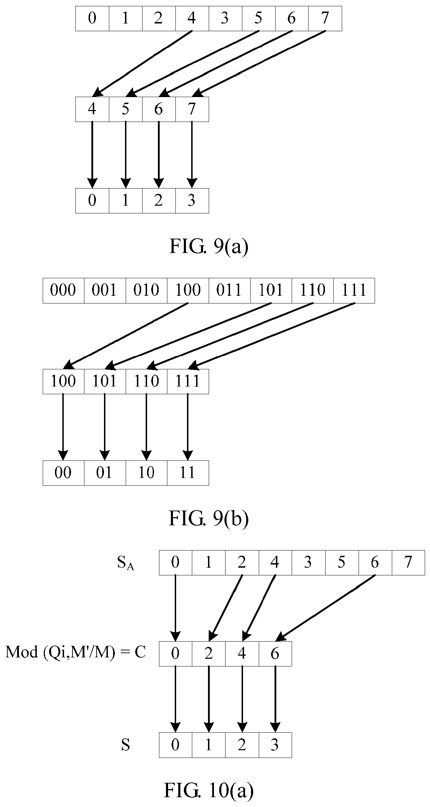

For example, if the sequence S' is a sequence {0,1,2,4,3,5,6,7} that has a length of 8, and if N * (1 - P') - L = 4, N' * (1 - P') - L channel indexes, which are {0,1,2,3}, may be extracted, as shown in FIG. 9(a).

For another example, if the sequence S' is a sequence {0,1,2,4,3,5,6,7} that has a length of 8 and is expressed in binary, as shown by row 1 in FIG. 9(b), and if N * (1 - P') - L = 4, a manner shown in FIG. 9(b) may be used to extract a binary index that has a bit equal to a fixed value (for example, a first bit is equal to 1) in each binary index in S'. Specifically, as shown by row 2 in FIG. 9(b), the first bit is removed, and an extracted channel index set {00,01,10,11} is formed.

408. Sequentially insert the N' * (1 - P') - L indexes into the foregoing L indexes whose positions are adjusted, to obtain a sequence $S_A$.

If S' is a Q sequence, the adjustment sequence is $\Delta Q_i$, and $\Delta Q_i$ includes a position offset of an index in a to-be-adjusted sequence, a wireless device may adjust positions of some of to-be-adjusted indexes based on $\Delta Q_i$. For example, the to-be-adjusted indexes are adjusted to corresponding positions based on the position offset included in $\Delta Q_i$, and then the N' * (1 - P') - L indexes are sequentially placed on positions on which the L indexes are not placed, for example, the positions shown by 506a in FIG. 5(a) or 506b in FIG. 5(b).

If S' is a Z sequence, the adjustment sequence is $\Delta Z_i$, and $\Delta Z_i$ includes reliability values of indexes in a to-be-adjusted sequence, the wireless device may adjust the reliability values included in $\Delta Z_i$ to corresponding positions, for example, the reliability values included in $\Delta Z_i$ and reliability values of the foregoing N' * (1 - P') - L channels may be re-sorted.

410. Obtain, based on the sequence $S_A$ formed in step 408, a constructed sequence S that has a length of M.

Assuming that a length of $S_A$ is M' = N' * (1 - P'), if M' = M, step 410 is not needed, that is, the sequence formed in step 408 is a final sequence S.

If a length M' of $S_A$ is greater than M, the constructed sequence S that has the length of M needs to be further extracted from $S_A$. There are a plurality of manners of extracting the constructed sequence S that has a length of M from $S_A$.

Manner (1): If $S_A$ is a Q sequence, a set of indexes that are extracted from $S_A$ and meet the following condition forms the foregoing constructed sequence S: $mod(Q_i, M'/M) = C$, where $Q_i$ is an $i^{th}$ index in $S_A$, $1 \le i < M'$, C is an integer, and $0 \le C < M'/M$.

For example, if $S_A$ is a sequence $\{0,1,2,4,3,5,6,7\}$ that has a length of 8, and M = 4, a manner shown in FIG. 10(a) may be used to form the final constructed sequence S, namely, $\{0,1,2,3\}$. Manner (2): If $S_A$ is a Q sequence, and $M'/M = 2^x$, the constructed sequence S is formed after indexes in $S_A$ are expressed in binary, and X bits and repeated binary index numbers are removed from $S_A$.

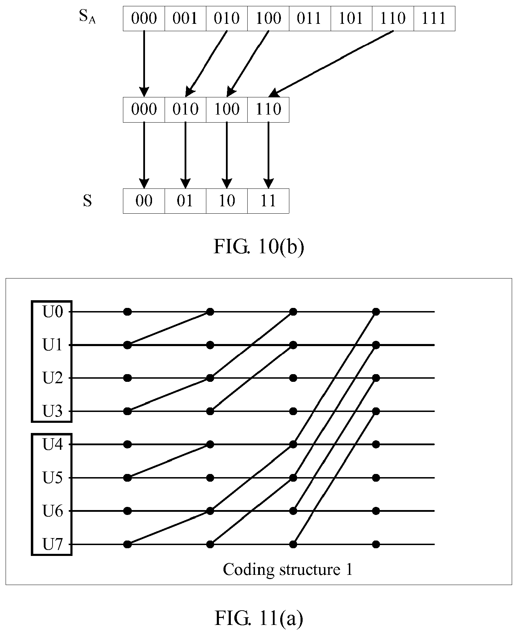

For example, if $S_A$ is a sequence $\{0,1,2,4,3,5,6,7\}$ that has a length of 8 and is expressed in binary, as shown by row 1 in FIG. 10(b), and if M = 4, a manner shown in FIG. 10(b) may be used to remove a last bit from each binary index in $S_A$ to form the final constructed sequence S, that is, $\{00,01,10,11\} = \{0,1,2,3\}$.

Manner (3): If $S_A$ is a Z sequence sorted by reliability, indexes may be extracted with a same spacing from the Z sequence to form the constructed sequence S. For example, assuming that the Z sequence is $\{Z_1, Z_2, ..., Z_{M'}\}$, $\{Z_1, Z3, Z5, ...\}$ may be extracted from the Z sequence to form the constructed sequence S. This example is given merely for ease of understanding. During specific implementation, a spacing needs to be set based on a value of M or a relationship between M and M'.

Manner (4): If $S_A$ is a Z sequence sorted by reliability, indexes may be extracted with a fixed spacing from the Z sequence to form the constructed sequence S.

For ease of understanding, the following gives specific examples for description.

As shown in FIG. 6, assuming that the length of S' is 16, as shown in FIG. 6, if the puncturing/shortening proportion P' = 1/4, it means that four indexes need to be removed from S'. It is assumed that indexes that need to be removed are $\{1,2,3,4\}$ that is shown by 602 in FIG. 6, indexes that need to be adjusted are $\{5,6,7,8\}$ that is shown by 604 in FIG. 6, and the adjustment sequence is $\{0,1,1,4\}$. The adjustment sequence may be understood as offsets (the offset may be a positive integer, 0, or a negative integer) of four indexes that need to be adjusted. As shown in FIG. 6, an index 5 corresponds to an adjustment offset 0, which indicates that a position of the index 5 does not need to be adjusted; an index 6 corresponds to an adjustment offset 1, which indicates that a position of the index 6 needs to be moved 1 bit backward; an index 7 corresponds to an adjustment offset 1, which indicates that a position of the index 7 needs to be moved 1 bit backward; and an index 8 corresponds to an adjustment offset 4, which indicates that a position of the index 8 needs to be moved 4 bits backward. After the moving, a position of $\{5,6,7,8\}$ is shown by 606 in FIG. 6.

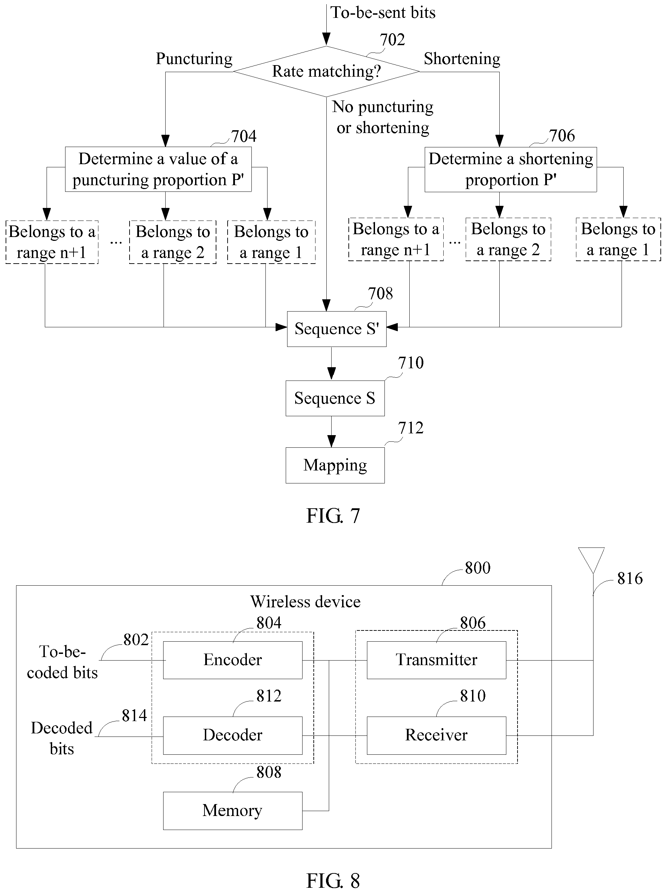

When the wireless device already stores a correspondence in any one of the foregoing Table 1 to Table 5, after receiving to-be-sent bits, the wireless device adjusts the sequence S based on rate matching, to form the final constructed sequence S. The following describes a procedure of the wireless device. For details, refer to FIG. 7.

702. After receiving to-be-sent bits, the wireless device determines whether to perform rate matching. If the rate matching is not required, for example, puncturing or shortening is not required, go to step 708. If the rate matching is required, the wireless device further determines a rate matching manner. If a puncturing manner is used, go to step 704; if a shortening manner is used, go to step 706.

704. Determine a value of a puncturing proportion P'.

706. Determine a value of a shortening proportion P'. (For ease of description, both the shortening proportion and the puncturing proportion are represented by P'. During actual application, however, the two values may be different, and correspondences between P' and S' may be different.)

If the wireless device stores a correspondence between P' and S' by using a form shown in Table 2 or 3, in step 704 or 706, the wireless device may further determine a range to which P' belongs.

708. Obtain a corresponding sequence S' based on the value of P'.

The wireless device already stores the correspondence between P' and S', for example, as shown in any one of Table 1 to Table 5, and the wireless device may find, by querying the

table, the sequence S' corresponding to P'.

710. The wireless device obtains, based on the sequence S', a constructed sequence S that has a length of M.

How to obtain, based on the sequence S', the constructed sequence S that has the length of M is described above. For details, refer to corresponding parts in FIG. 5 or FIG. 6. Details are not described herein again.

712. The wireless device maps the to-be-sent bit sequence to a channel corresponding to S.

The embodiments of the present invention further provide a method for extracting a short sequence from a long sequence. This method may be applied to extracting a constructed sequence S that has a length of M from a sequence S'. The length of the long sequence may be an integral power of 2 or may not be an integral power of 2.

For a non-mother code sequence, $M2 = (2^n) * M1$ is met between code lengths. For example, a code length of a 5G NR PDCCH may be a fixed value 96, 192, 384, or 768, a sequence that has a largest code length and that meets a nested feature may also be constructed, and a read manner is similar to a read manner (namely, manner (1) in step 410) of the largest mother code sequence. For a non-mother code sequence, puncturing or shortening positions for different code lengths need to meet symmetry shown in FIG. 11(a).

According to symmetry of a coding structure shown in FIG. 11(a),

M1 = 96 is obtained by puncturing or shortening based on N1 = 128, and a puncturing or shortening position is denoted as P1, P2, ..., P32;

M2 = 192 is obtained by puncturing or shortening based on N2 = 256, and a puncturing or shortening position is {PI, P2, ..., P32, P1+128, P2+128, ..., P32+128}; and M3 = 384 is obtained by puncturing or shortening based on N3 = 512, and a puncturing or shortening position is {PI, P2, ..., P32, P1+128, P2+128, ..., P32+128, P1+256, P2+256, ..., P32+256, P1+384, P2+384, ..., P32+384}.

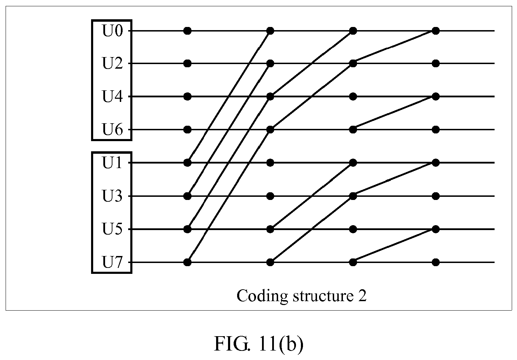

According to symmetry of a coding structure shown in FIG. 11(b),

M1 = 96 is obtained by puncturing or shortening based on N1 = 128, and a puncturing or shortening position is denoted as P1, P2, ..., P32;

M2 = 192 is obtained by puncturing or shortening based on N2 = 256, and a puncturing or shortening position is {P1, P2, ..., P32, P1+1, P2+1, ..., P32+1}; and

M3 = 384 is obtained by puncturing or shortening based on N3 = 512, and a puncturing or shortening position is {PI, P2, ..., P32, P1+1, P2+1, ..., P32+1, P1+2, P2+2, ..., P32+2, P1+3, P2+3, ..., P32+3}.

FIG. 8 is a schematic block diagram of a wireless device according to an embodiment of the present invention. As shown in FIG. 8, a wireless device 800 includes at least an encoder 804 and a memory 808.

The memory 808 is configured to store a correspondence between a puncturing/shortening proportion P' and a sequence S'.

The encoder 804 is configured to: obtain, based on the correspondence, stored in the memory, between the puncturing/shortening proportion P' and the sequence S', a constructed sequence S that has a length equal to a target code length M, where S' includes N' channel indexes sorted by channel reliability or channel capacity, and sorting of channel indexes in S is the same as or different from sorting of channel indexes in S'; and map a to-be-sent bit sequence to a channel corresponding to S.

Functions of the encoder 804 may be implemented by using a chip or an integrated circuit. If the functions of the encoder 804 are implemented by using a chip, the wireless device 800 may further include an interface 802. The encoder 804 is configured to obtain a to-be-sent bit sequence by using the interface 802, and the encoder 804 performs polar coding on the to-be-sent bit sequence to obtain an output bit sequence. The encoder may perform some or all of steps 302 to 304, or some or all of steps 402 to 410, or steps 702 to 712.

When performing steps 302 to 304, 402 to 410, or 702 to 712, the chip may be implemented by using a logic circuit or by using a processor, or implemented partially by using a logic circuit and partially by using a processor. If steps 302 to 304, 402 to 410, or 702 to 712 are implemented by using a processor, the memory 808 may store program code that is used to implement some or all of steps 302 to 304, 402 to 410, or 702 to 712. When executing the program code, the processor performs some or all of steps 302 to 304, 402 to 410, or 702 to 712. The memory 808 may be integrated inside a chip or may be disposed outside a chip.

For details about how to obtain a constructed sequence S from a sequence that has a length of S', refer to the foregoing description. Details are not described herein again.

The wireless device 800 may further include a transmitter 806, configured to send the bit sequence that is mapped by the encoder 804 to the channel corresponding to S.

The wireless device 800 may further include an antenna 816. The transmitter 806 is configured to send, by using the antenna 816, a bit sequence that is output by the encoder. If the wireless device is a terminal, the antenna 816 is probably integrated in the terminal. If the wireless device is a network device, the antenna 816 may be integrated in the network device, or may be separate from the network device, for example, the antenna 816 is connected to the network device in a remote manner.

In addition, the wireless device may further include a receiver 810, configured to receive information or data from another wireless device. A decoder 812 is configured to: obtain, based on the puncturing/shortening proportion P' and a prestored sequence S', the constructed sequence S that has the length equal to the target code length M, use the constructed sequence to decode the to-be-decoded bits, and then output decoded bits by using an interface 814. A method for obtaining, by the decoder, S based on S' is the same as that used on an encoder side. For details, refer to the description in the foregoing method embodiments. Details are not described herein again.

During actual application, the encoder 804 and the decoder 812 may be integrated together to form a codec or a codec apparatus, and the transmitter 806 and the receiver 810 may be integrated together to form a transceiver.

A non-claimed embodiment of the present invention further provides a chip. The chip includes at least the foregoing interface 802 and the encoder 804.

An embodiment of the present invention further provides a computer storage medium. The storage medium stores program code that is used to implement steps 302 to 304, 402~410, or 702 to 712.

According to the foregoing technical solutions provided in this application, a constructed sequence that is suitable for various puncturing/shortening proportions may be generated, and channel reliability sorting in the constructed sequence is more appropriate, thereby decreasing a bit error rate.

An embodiment of the present invention further provides an encoder, configured to perform the method corresponding to FIG. 11(a) or FIG. 11(b). The encoder may be applied to the wireless device shown in FIG. 8.

The storage medium includes: various media that can store program code, such as a USB flash drive, a removable hard disk, a read-only memory (ROM, Read-Only Memory), a random access memory (RAM, Random Access Memory), a magnetic disk, or an optical disc. An embodiment of the present invention further provides a computer program product. The computer program product includes program code that is used to implement steps 302 to 304, 402~410, or 702 to 712. The computer program product may be stored in the storage medium, or on a server, for download by a user.

Connection relationships between components or integral units mentioned in the foregoing embodiments may be direct connections or coupling, or may be indirect connections or coupling. Between two components or integral units, there may be another component or integral unit, which is not particularly related to the solutions of the embodiments of the present invention, and therefore is not shown in the figures.

According to the foregoing embodiments, the wireless device or the wireless communications system only needs to store a long sequence, and during coding, reads, from the long sequence, a mother code sequence having a length required for coding, thereby decreasing storage overheads of the wireless device or the system.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

**Claims**

1. A method comprising:

   performing polar coding on a bit sequence to obtain a polar-coded bit sequence;
   obtaining (302), based on a puncturing proportion P' and a prestored sequence S', a constructed sequence S that has a length equal to a target code length M, wherein the prestored sequence S' comprises N' channel indexes sorted by channel reliability, wherein N'>M, and wherein sorting of channel indexes in the constructed sequence S is the same as sorting of channel indexes in the prestored sequence S'; and

   mapping (304) the polar coded bit sequence to channels corresponding to the channel indexes in the constructed sequence S,
   wherein, when N' and M satisfy: $N' \times 3/4 < M < \beta \times (N' \times 3/4)$, where $\beta > 1$, channels corresponding to channel indexes that are less than N'/4 in the prestored sequence S' are frozen.

2. The method according to claim 1, wherein the constructed sequence S comprises the channel indexes of N' * (1 - P') channels.

3. The method according to claim 1 or 2, wherein the channels corresponding to the channel indexes of (N' * P') channels are punctured.

4. The method according to any one of claims 1 to 3, wherein $\beta = (1+1/16)$, $\beta = (1+1/8)$ or $\beta = (1+3/16)$.

5. The method according to claim 1, wherein the constructed sequence S is obtained, after N' * P' channels are removed from N' channels corresponding to the prestored sequence S', by adjusting the channel indexes of the remaining N' * (1 - P') channels based on a preset adjustment sequence, and the constructed sequence S comprises some or all of the channel indexes of the remaining N' * (1 - P') channels.

6. The method according to claim 5, wherein the values of the preset adjustment sequence are all zeros.

7. A wireless device, comprising:

   a memory, configured to store a relationship between the puncturing proportion P' and the prestored sequence S'; and
   an encoder, configured to perform the method according to any one of claims 1 to 6.

8. A computer program product, wherein the computer program product includes program code, wherein, when the program code is executed, the method according to any one of claims 1 to 6 is performed.

9. An apparatus, comprising:

   means for performing polar coding on a bit sequence to obtain a polar-coded bit sequence;
   means for obtaining, based on a puncturing proportion P' and a prestored sequence S', a constructed sequence S that has a length equal to a target code length M, wherein the prestored sequence S' comprises N' channel indexes sorted by channel reliability, wherein N'>M, and wherein sorting of channel indexes in the constructed sequence S is the same as sorting of channel indexes in the prestored sequence S'; and

means for mapping the polar coded bit sequence to channels corresponding to the channel indexes in the constructed sequence S, wherein, when N' and M satisfy: $N' \times 3/4 < M < \beta \times (N' \times 3/4)$, where $\beta > 1$, channels corresponding to channel indexes that are less than N'/4 in the prestored sequence S' are frozen.

10. The apparatus according to claim 9, wherein the contructed sequence S comprises the channel indexes of N' * (1 - P') channels.

11. The apparatus according to claim 9 or 10, wherein the channels corresponding to the channel indexes of (N' * P') channels are punctured.

12. The apparatus according to any one of claims 9 to 11, wherein $\beta = (1+1/16)$, $\beta = (1+1/8)$ or $\beta = (1+3/16)$.

13. The apparatus according to claim 9, wherein the constructed sequence S is obtained, after N' * P' channels are removed from N' channels corresponding to the prestored sequence S', by adjusting the channel indexes of the remaining N' * (1 - P') channels based on a preset adjustment sequence, wherein the constructed sequence S comprises some or all of the channel indexes of the remaining N' * (1 - P') channels.

14. The apparatus according to claim 13, wherein the values of the preset adjustment sequence are all zeros.

## Patentansprüche

1. Verfahren, Folgendes umfassend:

Durchführen von Polar-Codierung an einer Bitsequenz, um eine polar-codierte Bitsequenz zu erhalten;
Erhalten (302), basierend auf einem Punktierungsverhältnis P' und einer vorgespeicherten Sequenz S', einer konstruierten Sequenz S, die eine Länge gleich einer Zielcodelänge M hat, wobei die vorgespeicherte Sequenz S' nach Kanalzuverlässigkeit sortierte N' Kanal-Indizes umfasst, wobei N'>M, und wobei das Sortieren von Kanal-Indizes in der konstruierten Sequenz S das gleiche ist wie das Sortieren von Kanal-Indizes in der vorgespeicherten Sequenz S'; und
Zuordnen (304) der polar-codierten Bitsequenz zu Kanälen, die den Kanal-Indizes in der konstruierten Sequenz S entsprechen,

wobei, wenn N' und M Folgendes erfüllen: $N' \times 3/4 < M < \beta \times (N' \times 3/4)$, wobei $\beta > 1$, Kanäle, die Kanal-Indizes entsprechen, die kleiner als N'/4 in der vorgespeicherten Sequenz S' sind, eingefroren werden.

2. Verfahren gemäß Anspruch 1, wobei die konstruierte Sequenz S die Kanal-Indizes von N'*(1-P') Kanälen umfasst.

3. Verfahren gemäß Anspruch 1 oder 2, wobei die Kanäle, die den Kanal-Indizes von (N'*P') Kanälen entsprechen, punktiert werden.

4. Verfahren gemäß einem der Ansprüche 1 bis 3, wobei $\beta = (1+1/16)$, $\beta = (1+1/8)$ oder $\beta = (1+3/16)$.

5. Verfahren gemäß Anspruch 1, wobei die konstruierte Sequenz S erhalten wird, nachdem N'*P' Kanäle von N' Kanälen, die der vorgespeicherten Sequenz S' entsprechen, entfernt worden sind, indem die Kanal-Indizes der verbleibenden N'*(1-P') Kanäle, basierend auf einer voreingestellten Einstellungssequenz, angepasst werden, und die konstruierte Sequenz S einige oder alle der Kanal-Indizes der verbleibenden N'*(1-P') Kanäle umfasst.

6. Verfahren gemäß Anspruch 5, wobei die Werte der voreingestellten Einstellungssequenz alles Nullen sind.

7. Drahtlosgerät, Folgendes umfassend:

einen Speicher, der dazu ausgelegt ist, eine Beziehung zwischen dem Punktierungsverhältnis P' und der vorgespeicherten Sequenz S' zu speichern; und
einen Codierer, der dazu ausgelegt ist, das Verfahren gemäß einem der Ansprüche 1 bis 6 durchzuführen.

8. Computerprogrammprodukt, wobei das Computerprogrammprodukt Programmcode enthält, wobei, wenn der Programmcode ausgeführt wird, das Verfahren gemäß einem der Ansprüche 1 bis 6 durchgeführt wird.

9. Vorrichtung, Folgendes umfassend:

Mittel zum Durchführen von Polar-Codierung an einer Bitsequenz, um eine polar-codierte Bitsequenz zu erhalten;
Mittel zum Erhalten, basierend auf einem Punktierungsverhältnis P' und einer vorgespeicherten Sequenz S', einer konstruierten Sequenz S, die eine Länge gleich einer Zielcodelänge M hat, wobei die vorgespeicherte Sequenz S' nach Kanalzuverlässigkeit sortierte N' Kanal-Indizes umfasst, wobei N'>M, und wobei das Sortieren von Kanal-Indizes in der konstruierten Sequenz S das gleiche ist wie das Sortieren von Kanal-Indizes in der vorgespeicherten Sequenz S'; und

Mittel zum Zuordnen der polar-codierten Bitsequenz zu Kanälen, die den Kanal-Indizes in der konstruierten Sequenz S entsprechen, wobei, wenn N' und M Folgendes erfüllen: N'×3/4<M<β×(N'×3/4), wobei β>1, Kanäle, die Kanal-Indizes entsprechen, die kleiner als N'/4 in der vorgespeicherten Sequenz S' sind, eingefroren werden.

10. Vorrichtung gemäß Anspruch 9, wobei die konstruierte Sequenz S die Kanal-Indizes von N'*(1-P') Kanälen umfasst.

11. Vorrichtung gemäß Anspruch 9 oder 10, wobei die Kanäle, die den Kanal-Indizes von (N'*P') Kanälen entsprechen, punktiert werden.

12. Vorrichtung gemäß einem der Ansprüche 9 bis 11, wobei β=(1+1/16), β=(1+1/8) oder β=(1+3/16).

13. Vorrichtung gemäß Anspruch 9, wobei die konstruierte Sequenz S erhalten wird, nachdem N'*P' Kanäle von N' Kanälen, die der vorgespeicherten Sequenz S' entsprechen, entfernt worden sind, indem die Kanal-Indizes der verbleibenden N'*(1-P') Kanäle, basierend auf einer voreingestellten Einstellungssequenz, angepasst werden, wobei die konstruierte Sequenz S einige oder alle der Kanal-Indizes der verbleibenden N'*(1-P') Kanäle umfasst.

14. Vorrichtung gemäß Anspruch 13, wobei die Werte der voreingestellten Einstellungssequenz alles Nullen sind.

**Revendications**

1. Procédé comprenant :

l'exécution d'un codage polaire sur une séquence binaire pour obtenir une séquence binaire codée polaire ;
l'obtention (302), sur la base d'une proportion P' de perforation et d'une séquence S' pré-stockée, d'une séquence S construite qui présente une longueur égale à une longueur de code cible M, dans lequel la séquence S' pré-stockée comprend N' indices de canaux triés par une fiabilité de canal, dans lequel N'>M, et dans lequel le triage des indices de canaux dans la séquence S construite est le même que le triage des indices de canaux dans la séquence S' pré-stockée ; et

le mappage (304) de la séquence binaire codée polaire sur des canaux correspondant aux indices de canaux dans la séquence S construite, dans lequel, lorsque N' et M satisfont : N'×3/4<M<β×(N'×3/4), où β>1, des canaux correspondant aux indices de canaux qui sont inférieurs à N'/4 dans la séquence S' pré-stockée sont gelés.

2. Procédé selon la revendication 1, dans lequel la séquence S construite comprend les indices de canaux de N'*(1-P') canaux.

3. Procédé selon la revendication 1 ou 2, dans lequel les canaux correspondant aux indices de canaux de (N'*P') canaux sont perforés.

4. Procédé selon l'une quelconque des revendications 1 à 3, dans lequel β=(1+1/16), β=(1+1/8) ou β=(1+3/16).

5. Procédé selon la revendication 1, dans lequel la séquence S construite est obtenue, après que N'*P' canaux sont supprimés des N' canaux correspondant à la séquence S' pré-stockée, en réglant les indices de canaux des N'*(1-P') canaux restants sur la base d'une séquence de réglage prédéfinie, et la séquence S construite comprend certains ou la totalité des indices de canaux des N'*(1-P') canaux restants.

6. Procédé selon la revendication 5, dans lequel les valeurs de la séquence de réglage prédéfinie sont toutes nulles.

7. Dispositif sans fil, comprenant :

une mémoire, configurée pour stocker une relation entre la proportion P' de perforation et la séquence S' pré-stockée ; et
un codeur, configuré pour mettre en œuvre le procédé selon l'une quelconque des revendications 1 à 6.

8. Produit de programme informatique, dans lequel le produit de programme informatique inclut un code de programme, dans lequel, lorsque le code de programme est exécuté, le procédé est mis en œuvre selon l'une quelconque des revendications 1 à 6.

9. Appareil, comprenant :

un moyen d'exécuter un codage polaire sur une séquence binaire pour obtenir une séquence binaire codée polaire ;
un moyen d'obtenir, sur la base d'une proportion P' de perforation et d'une séquence S' pré-stockée, une séquence S construite qui présente une longueur égale à une longueur de code cible M, dans lequel la séquence S' pré-stockée comprend N' indices de canaux triés par une fiabilité de canal, dans lequel N'>M, et dans lequel le triage des indices de canaux dans la séquence S construite est le même que le triage des indices de canaux dans la séquence S' préstockée ; et

un moyen de mapper la séquence binaire codée polaire sur des canaux correspondant aux indices de canaux dans la séquence S construite, dans lequel, lorsque N' et M satisfont : $N' \times 3/4 < M < \beta \times (N' \times 3/4)$, où $\beta > 1$, des canaux correspondant aux indices de canaux qui sont inférieurs à N'/4 dans la séquence S' pré-stockée sont gelés.

10. Appareil selon la revendication 9, dans lequel la séquence S construite comprend les indices de canaux de N'*(1-P') canaux.

11. Appareil selon la revendication 9 ou 10, dans lequel les canaux correspondant aux indices de canaux de (N'*P') canaux sont perforés.

12. Appareil selon l'une quelconque des revendications 9 à 11, dans lequel $\beta=(1+1/16)$, $\beta=(1+1/8)$ ou $\beta=(1+3/16)$.

13. Appareil selon la revendication 9, dans lequel la séquence S construite est obtenue, après que N'*P' canaux sont supprimés des N' canaux correspondant à la séquence S' pré-stockée, en réglant les indices de canaux des N'*(1-P') canaux restants sur la base d'une séquence de réglage prédéfinie, dans lequel la séquence S construite comprend certains ou la totalité des indices de canaux des N'*(1-P') canaux restants.

14. Appareil selon la revendication 13, dans lequel les valeurs de la séquence de réglage prédéfinie sont toutes nulles.

FIG. 1

FIG. 2

P', S'

302

Obtain a sequence S that has a length equal to a target code length M

304

Map a to-be-sent bit sequence to a channel corresponding to S

FIG. 3

402

Remove punctured/shortened N' * P' channel indexes from N' channel indexes of a sequence S'

404

Adjust positions of to-be-adjusted L channel indexes

406

Extract N' * (1 – P') – L indexes from S'

408

Sequentially insert the N' * (1 – P') – L indexes into the L indexes whose positions are adjusted

410

Obtain a sequence S

FIG. 4

Indexes frozen due to
puncturing or shortening      $N' * (1 - P')$ channel indexes

| $N' * P'$ | To-be-adjusted L indexes | $N' * (1 - P') - L$ indexes sequentially extracted from S' |
|---|---|---|

502a     504a     N' channel indexes     506a

FIG. 5(a)

N' channel indexes

502b      504b      506b
Indexes frozen    To-be-adjusted L    $N' * (1 - P') - L$ indexes
due to puncturing     indexes     sequentially extracted from S'
or shortening

FIG. 5(b)

602        604

Sequence S' ⟹ | 1 | 2 | 3 | 4 | 5 | 6 | 7 | 8 | 9 | 10 | 11 | 13 | 12 | 14 | 15 | 16 |

Adjustment sequence ⟹ { 0, 1, 1, 4 }

606

Sequence S ⟹ | 5 | 9 | 6 | 7 | 10 | 11 | 13 | 8 | 12 | 14 | 15 | 16 |

FIG. 6

To-be-sent bits

702

Puncturing — Rate matching? — Shortening

No puncturing
or shortening

704

Determine a value of a
puncturing proportion P'

706

Determine a shortening
proportion P'

Belongs to a
range n+1 ... Belongs to
a range 2 Belongs to
a range 1

Belongs to a
range n+1 ... Belongs to
a range 2 Belongs to
a range 1

708

Sequence S'

710

Sequence S

712

Mapping

FIG. 7

800

816

Wireless device

804

802

To-be-
coded bits

Encoder

806

Transmitter

812

814

Decoded
bits

Decoder

810

Receiver

808

Memory

FIG. 8

| 0 | 1 | 2 | 4 | 3 | 5 | 6 | 7 |
|---|---|---|---|---|---|---|---|

| 4 | 5 | 6 | 7 |
|---|---|---|---|

| 0 | 1 | 2 | 3 |
|---|---|---|---|

FIG. 9(a)

| 000 | 001 | 010 | 100 | 011 | 101 | 110 | 111 |
|-----|-----|-----|-----|-----|-----|-----|-----|

| 100 | 101 | 110 | 111 |
|-----|-----|-----|-----|

| 00 | 01 | 10 | 11 |
|----|----|----|----|

FIG. 9(b)

$S_A$

| 0 | 1 | 2 | 4 | 3 | 5 | 6 | 7 |
|---|---|---|---|---|---|---|---|

$Mod\,(Qi, M'/M) = C$

| 0 | 2 | 4 | 6 |
|---|---|---|---|

$S$

| 0 | 1 | 2 | 3 |
|---|---|---|---|

FIG. 10(a)

$S_A$ | 000 | 001 | 010 | 100 | 011 | 101 | 110 | 111 |

| 000 | 010 | 100 | 110 |

S | 00 | 01 | 10 | 11 |

## FIG. 10(b)

U0
U1
U2
U3
U4
U5
U6
U7

Coding structure 1

## FIG. 11(a)

Coding structure 2

FIG. 11(b)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017215494 A

**Non-patent literature cited in the description**

- POLAR CODES CONSTRUCTION AND RATE MATCHING SCHEME_FINAL. 3RD GENERATION PARTNERSHIP PROJECT (3GPP). MOBILE COMPETENCE CENTRE, 07 May 2017